# EUROPÄISCHE PATENTSCHRIFT

(11) **EP 2 625 724 B1**
(45) Veröffentlichungstag und Bekanntmachung des Hinweises auf die Patenterteilung: **30.11.2016**
(21) Anmeldenummer: 11766989.5
(22) Anmeldetag: 05.10.2011
(51) Int. Cl.: H01L 33/50, H01L 33/64

(54) **OPTOELEKTRONISCHES HALBLEITERBAUELEMENT UND VERFAHREN ZU SEINER HERSTELLUNG**
OPTOELECTRONIC SEMICONDUCTOR COMPONENT AND METHOD FOR PRODUCING SAME
COMPOSANT SEMI-CONDUCTEUR OPTO-ÉLECTRONIQUE ET SON PROCÉDÉ DE PRODUCTION

(30) Priorität: 08.10.2010 DE 102010042217
(43) Veröffentlichungstag der Anmeldung: 14.08.2013
(73) Patentinhaber: OSRAM GmbH, 80807 München (DE)
(72) Erfinder: EBERHARDT, Angela, 86157 Augsburg (DE); HÜTTINGER, Roland, 86916 Kaufering (DE); SCHMIDT, Reinhold, 86179 Augsburg (DE); KOTTER, Stefan, 86199 Augsburg (DE)
(86) Internationale Anmeldenummer: PCT/EP2011/067381
(87) Internationale Veröffentlichungsnummer: WO 2012/045772

(56) Entgegenhaltungen:
- WO-A1-2006/122524
- DE-A1-102004 019 802
- DE-A1-102007 055 170
- DE-A1-102007 057 812
- DE-A1-102008 021 666
- US-A1- 2009 001 390

## Beschreibung

Die Erfindung geht aus von einem optoelektronischen Halbleiterbauelement gemäß dem Oberbegriff des Anspruchs 1, insbesondere eine Konversions-LED. Sie beschreibt auch ein zugehöriges Herstellungsverfahren gemäß dem Oberbegriff des Anspruchs 9.

Die US 5 998 925 offenbart eine typische weiße LED. Dabei wird typisch der Leuchtstoff in Silikon suspendiert und dann auf den Chip aufgebracht, meist wird sie siebgedruckt. Die Schichten sind ca. 30 µm dick. Silikon besitzt eine schlechte Wärmeleitfähigkeit, die dazu führt, dass sich der Leuchtstoff im Betrieb stärker erwärmt und dadurch ineffizienter wird. Derzeit wird das Konversionselement mit einem organischen Kleber auf dem Chip befestigt.

Die WO 2006/122524 beschreibt eine Lumineszenzkonversions-LED, die einen Leuchtstoff verwendet, der in Glas eingebettet ist.

Die US 2009/001390 A1 (YAN XIANTAO [US] ET AL) beschreibt eine Leuchtdiode mit Lumineszenzkonversions-Glasmatrix.

### Darstellung der Erfindung

Eine Aufgabe der vorliegenden Erfindung ist es, bei einem optoelektronisches Halbleiterbauelement gemäß dem Oberbegriff des Anspruchs 1 eine verbesserte Lösung für das Problem der Wärmeabfuhr beim Konversionselement anzugeben. Eine weitere Aufgabe ist es, dafür ein Herstellverfahren anzugeben.

Diese Aufgabe wird gelöst durch die kennzeichnenden Merkmale der Ansprüche 1 und 9.

Besonders vorteilhafte Ausgestaltungen finden sich in den abhängigen Ansprüchen.

Die vorliegende Erfindung löst das folgende Problem: verbesserte Effizienz und Lebensdauer der LED durch stärkere Wärmeabfuhr des Konversionselements durch Ersatz des organischen Materials (Kunststoff) durch Glas und Keramik oder Glaskeramik, welche eine bessere Wärmeleitfähigkeit und UV-Beständigkeit besitzen.

Beispielhaft wird ein modifizierter Ansatz eines separaten Konversionselements, das strukturiert ist, verwendet: Einsatz einer dünnen transparenten oder transluzenten Keramik- oder Glaskeramikfolie als Substrat oder Trägermaterial. Die Dicke der Trägerfolie liegt im Bereich ≥ 1 µm bis ≤ 100 µm, vorzugsweise ≥ 3 µm bis ≤ 50 µm, insbesondere ≥ 5 µm bis ≤ 20 µm. Diese Folie kann z. B. durch Doktor-Blade-Verfahren hergestellt und anschließend thermisch versintert werden. Im Anschluss wird auf die Folie eine dünne kompakte und relativ blasenarme Glasschicht laminiert. Die Bedeutung einer blasenarmen Schicht liegt in ihrer reduzierten Streuwirkung. Der Begriff blasenarm bedeutet insbesondere, dass der Anteil der Blasen in der Glasschicht höchstens 10 vol.-%, bevorzugt höchstens 5 vol.-%, besonders bevorzugt höchstens 1 vol.-% ausmacht. Durch die Temperaturführung bei der Herstellung der Glasmatrix kann dieser Parameter gezielt eingestellt werden. Je höher die Temperatur desto blasenärmer wird die Glasschicht. Das Einsinken des Leuchtstoffs wird im Vergleich dazu bei deutlich niedrigeren Temperaturen durchgeführt um eine Schädigung des Leuchtstoffs möglichst zu vermeiden.

Je blasenärmer die Glasschicht, desto dünner kann die Glasschicht gewählt werden. Dies verbessert die Homogenität der Abstrahlung, also die Änderung des Farborts über den Winkel. Je geringer die Dicke der Glasschicht, desto mehr wird die unerwünschte seitliche Abstrahlung reduziert.

Die Dicke der Glasschicht ist ≤ 200 µm, vorzugsweise ≤ 100 µm, insbesondere ≤ 50 µm, aber mindestens so hoch wie die größten Leuchtstoffpartikel. Diese Schicht kann z. B. durch Siebdruck von Glaspulver mit anschließender Verglasung oder durch Aufziehen von geschmolzenem Glas direkt auf die Folie aufgebracht werden. Als Material für das Substrat eignet sich bevorzugt Al₂O₃, YAG, AlN, AlON, SiAlON oder eine Glaskeramik. Als Material für die Glasschicht eignet sich bevorzugt ein niedrigschmelzendes Glas, vorzugsweise bleifrei oder bleiarm, mit einer Erweichungstemperatur < 500°C, bevorzugt 350 bis 480°C, wie beispielsweise in DE 10 2010 009 456.0 beschrieben. Bevorzugt bildet dieses System ein Laminat.

Im Anschluss wird ein Leuchtstoff durch z. B. Siebdruck oder Sprühverfahren auf die Glasschicht des Laminats aufgebracht. Das mit Leuchtstoff beschichtete Laminat wird dann soweit erwärmt (insbesondere liegt dabei die Temperatur höchstens beim sog. Halbkugelpunkt des Glases, insbesondere bei mindestens Tg des Glases, besonders bevorzugt bei mindestens der Erweichungstemperatur des Glases), dass das Glas nur leicht erweicht und der Leuchtstoff in die Glasschicht einsinkt und davon umschlossen wird. Der Vorteil des Einsinkens ist, dass hierfür nur niedrige Temperaturen erforderlich sind und dadurch der Leuchtstoff nicht geschädigt wird. Im Falle des Glases aus DE 10 2010 009 456.0 ist dies eine Temperatur von höchstens 350°C. Als Leuchtstoff eignen sich grundsätzlich alle bekannten für die LED-Konversion geeigneten Leuchtstoffe oder Mischungen von Leuchtstoffen wie insbesondere Granate, Nitridosilikate, Orthosilikate, Sione, Sialone, Calsine etc.

Ein weiteres Beispiel ist die Aufbringung einer Pulvermischung aus Glaspulver und Leuchtstoff auf die versinterte Folie, dem Substrat. Hierzu sind im Vergleich zum Einsinken aber deutlich höhere Temperaturen erforderlich, insbesondere eine Temperatur, die mindestens dem Fließpunkt des Glases und bevorzugt höchstens der Läutertemperatur des Glases entspricht, um eine blasenarme Schicht zu erzeugen, da dass Glas hierzu sehr niederviskos sein muss, so dass die eingeschlossene Luft entweichen kann und die Leuchtstoffpartikel außerdem viskositätserhöhend wirken. Eventuell sind Zusatzprozesse wie z. B. Vakuum während des Versinterns notwendig. Im Falle des Glases aus DE 10 2010 009 456.0 wäre dies bei Temperaturen von mindestens 400°C.

Erfindungsgemäß ist es möglich, das Substrat als sehr dünne Folie aus Keramik oder Glaskeramik zu wählen und dann mit Glas zu infiltrieren. Im Vergleich zu beiden eingangs genannten Beispielen, muss das Substrat in diesem Fall nur leicht versintert werden, hierzu wird die Sintertemperatur gegenüber einem "kompakteren" Sintern erniedrigt oder die Sinterzeit verkürzt; d. h. nur so hoch gewählt, dass die Partikel der Keramik miteinander fixiert sind und viele Poren verbleiben, also ein poröser Körper entsteht. Die Porosität liegt im Bereich zwischen 30-70 Volumen-%, bevorzugt bei mindestens 50%. Im Anschluss wird eine dünne, mindestens 1 µm und höchstens 200 µm dicke Glasschicht direkt aufgebracht und dann auf eine Temperatur erwärmt, die mindestens dem Fließpunkt des Glases, bevorzugt höchstens der Läutertemperatur des Glases, entspricht, so dass das Glas sehr dünnflüssig wird und durch Kapillarwirkung in die poröse Folie, die das Substrat darstellt, gezogen wird. Dadurch wird das eigentliche Substrat gebildet. Bei dem Glas handelt es sich vorzugsweise um ein niedrigschmelzendes Glas, vorzugsweise bleifrei oder bleiarm, mit einer Erweichungstemperatur von höchstens 500°C wie beispielsweise in DE 10 2010 009 456.0 beschrieben. Die Temperaturen zum Infiltrieren liegen in diesem Fall bei mindestens 400°C, vorzugsweise mindestens 500°C.

Dabei kann gezielt ein Glasüberschuss auf die Folie aufgebracht werden, damit auf der Oberfläche der Folie eine dünne Glasschicht verbleibt.

Den dann auf das Substrat aufgebrachten Leuchtstoff lässt man bei relativ niedrigen Temperaturen von mindestens 50°C, bevorzugt bei höheren Temperaturen, d.h. bei einer Temperatur, die höchstens dem Halbkugelpunkt des Glases entspricht, in das Substrat, genauer in das in den Poren enthaltene Glas, einsinken. Im Falle des Glases aus DE 10 2010 009 456.0 ist dies eine Temperatur von höchstens 350°C.

Bei einem Glasüberschuss verbleibt in einem ersten Ausführungsbeispiel auf der Oberfläche der Folie eine dünne Glasschicht, in die der Leuchtstoff einsinkt. In diesem Fall ist die Haftung wesentlich robuster als bei einem Laminat.

Ist bei einem zweiten Ausführungsbeispiel ein Glasüberschuss an der Folienoberfläche nicht gegeben, sinkt der Leuchtstoff in die Oberflächenstruktur der Glas-Keramik-Mischung des Substrats ein.

Das Konversionselement kann entweder mit einem anorganischen Kleber wie einem niedrigschmelzenden Glas oder einem anorganischen Sol-Gel als auch mit organischem Kleber wie Silikon oder auch einem organischen Sol-Gel auf dem Chip befestigt werden. Ebenfalls kann es als "remote phosphor", also mit Abstand zum Chip, eingesetzt werden.

In einer besonderen Ausgestaltung ist das eingesetzte Glas des Substrats, insbesondere des Laminats, niedrigschmelzend und dient gleichzeitig als anorganischer Kleber zwischen Konversionselement und Chip. Ein derartiges Glas ist beispielsweise in der DE 10 2010 009 456.0 beschrieben und ermöglicht ein Einsinken des Leuchtstoffs und ein Verkleben von Chip und Konversionselement bei Temperaturen ≤ 350°C. Das Glas ist in diesem Fall dem Chip zugewandt.

In einer weiteren Ausgestaltung kann die Folie beidseitig mit Glas und ggf. mit Leuchtstoff auf einer oder beiden Seiten beschichtet sein. Das Aufbringen des Glases geschieht z. B. durch Eintauchen, sog. Dippen, der Folie in die Glasschmelze. Anschließend erfolgt die Leuchtstoffbeschichtung sowie das Einsinken des Leuchtstoffs in das Glas bei niedrigen Temperaturen, ggf. in zwei Schritten.

Das Substrat, insbesondere Laminat, kann auch ein Sandwich sein, d. h. die Glasschicht mit dem eingesunkenen Leuchtstoff befindet sich zwischen zwei Folien, die aus dem gleichen oder aus verschiedenen Materialien bestehen und ein- oder beidseitig mit Glas beschichtet sind. Das Glasmaterial kann dabei verschieden gewählt sein.

Vorzugsweise ist das Glas hochbrechend (vorzugsweise n>1.8), insbesondere ist der Brechungsindex des Glases ähnlich dem Brechungsindex der eingebetteten Leuchtstoffkomponente oder der Leuchtstoffkomponenten und ähnlich dem der Keramik/Glaskeramik gewählt.

Die Keramik- oder Glaskeramikfolie kann dem Chip zu- oder abgewandt sein. In letzterem Fall hat die Keramik auch eine lichtstreuende Wirkung. Letztere hängt u. a. von der Korngröße der in der Keramik oder Glaskeramik enthaltenen Partikel ab und kann mitunter durch die Temperaturbehandlung beeinflusst werden. Die Korngröße liegt typischerweise bei ≤ 60 µm, bevorzugt bei ≤ 40 µm, besonders bevorzug ≤ 30 µm. Sie sollte wenigstens 1 nm, besser wenigstens 5 nm, noch besser wenigstens 10 nm betragen, für viele Anwendungen ist ein Mindestwert von 100 nm ausreichend.

Vorzugsweise wird ein Bündel von Konversionselementen, insbesondere auf Laminat-Basis, als größeres Teil in einem Arbeitsgang hergestellt und erst dann in kleinere Teile, den eigentlichen Konversionselementen, geschnitten.

Die Dicke der Glasschicht mit dem eingesunkenen Leuchtstoff sollte bevorzugt ≤ 200 µm sein, vorzugsweise ≤ 100 µm, insbesondere ≤ 50 µm. Bevorzugt ist die Dicke der Glasschicht mindestens so hoch wie die größten Leuchtstoffpartikel des verwendeten Leuchtstoffpulvers, insbesondere mindestens doppelt so dick.

Als Glasmatrix eignen sich beispielsweise Phosphatgläser und Boratgläser, insbesondere Alkaliphosphatgläser, Aluminiumphosphatgläser, Zinkphosphatgläser, Phospotelluritgläser, Bismuthboratgläser, Zinkboratgläser und Zink-Bismuth-Boratgläser.

Darunter fallen Zusammensetzungen aus den Systemen:

R₂O-ZnO-Al₂O₃-B₂O₃-P₂O₅ (R₂O = Alkalioxid) ;

R₂O-TeO₂-P₂O₅(R₂O = Alkali- und/oder Silberoxid), auch in Verbindung mit ZnO und/oder Nb₂O₅ wie z.B. Ag₂O-TeO₂-P₂O₅ ZnO-Nb₂O₅;
ZnO-Bi₂O₃-B₂O₃, auch in Verbindung mit SiO₂ und/oder Alkali- und/oder Erdalkalioxid und/oder Al₂O₃ wie z.B. ZnO-Bi₂O₃-B₂O₃-SiO₂ oder ZnO-Bi₂O₃-B₂O₃-BaO-SrO-SiO₂;
ZnO-B₂O₃, auch in Verbindung mit SiO₂ und/oder Alkali- und/oder Erdalkalioxid und/oder Al₂O₃ wie z.B. ZnO-B₂O₃-SiO₂;
Bi₂O₃-B₂O₃, auch in Verbindung mit SiO₂ und/oder Alkakli- und/oder Erdalkalioxid und/oder Al₂O₃ wie z.B. Bi₂O₃-B₂O₃-SiO₂.

Bleiboratgläser sind im Prinzip zwar geeignet, werden jedoch nicht bevorzugt, da sie nicht RoHS-konform sind.

Die Trägerfolie kann aus einer Keramik wie z.B. Al₂O₃, YAG, AlN, AlON, SiAlON usw. oder einer Glaskeramik bestehen. Die Dicke der Trägerfolie liegt bevorzugt im Bereich ≤ 100 µm, vorzugsweise ≤ 50 µm, insbesondere ≤ 20 µm. Sie sollte aber mindestens 1 µm, besser 3 µm, bevorzugt mindestens 5 µm dick sein.

In einer weiteren Ausführungsform können die in der Glaskeramik enthaltenen Kristalle selbst durch Anregung der primären Emission des Chips zur Fluoreszenz angeregt werden und so zur Konversion mit beitragen. Ein bekanntes Beispiel ist YAG:Ce.

In einer besonders bevorzugten Ausgestaltung enthält die Keramikfolie einen Leuchtstoff wie z. B. YAG:Ce, bzw. sie besteht teilweise oder vollständig aus diesem. Im Anschluss wird auf die Keramikfolie eine dünne blasenarme Glasschicht laminiert, worauf ein separater Leuchtstoff aufgebracht wird. Dieser sinkt durch eine nachfolgende leichte Erwärmung in das Glas ein. Bei dem aufgebrachten separaten Leuchtstoff kann es sich in aller Regel um eine anderen Leuchtstoff handeln, dessen Emission in einem anderen Spektralbereich liegt als der des gelb emittierenden YAG:Ce. Z.B. ist der separate Leuchtstoff ein Rot emittierender Leuchtstoff, wodurch mit einem blau emittierenden Chip und der gelb emittierenden Keramik warmweißes Licht erzeugt wird. Durch Wahl des Anteil des weiteren Leuchtstoffs kann der Farbort der LED gesteuert werden.

Auch ist es möglich, dass ein gleicher oder ähnlicher Leuchtstoff wie der in der Keramik des Substrats bereits eingebrachte Leuchtstoff zusätzlich in die Glasschicht eingebracht wird, um z.B. eine chipbedingte Farbortschwankung (Drift) auszugleichen. Es können auch mehrere Leuchtstoffsorten in der glasigen Schicht des Konversionselements enthalten sein. Diese müssen dabei nicht unbedingt gleichmäßig verteilt sein, sie können auch lokal verschieden eingebracht sein. Ferner können dem Leuchtstoff auch oxidische Partikel wie z.B. Al₂O₃, TiO₂, ZrO₂ als Streumittel zugesetzt sein.

In einer weiteren Ausgestaltung werden zwei Keramiken, die den Leuchtstoff bereits beinhalten (Keramikkonverter), dünn mit Glas beschichtet. Die glasige Schicht eines der beiden Keramikplättchen wird dann mit Leuchtstoff beschichtet, der nach einer Temperaturbehandlung in diese einsinkt. Im Anschluss werden die glasigen Oberflächen der beiden Keramikplättchen aufeinander gelegt und in einem weiteren Temperaturschritt miteinander verklebt. In der Regel unterscheidet sich dabei der Farbort der beiden Keramikplättchen von dem des eingesunkenen Leuchtstoffes.

In einer besonderen Ausgestaltung des Vorgängerbeispiels wird nur ein Keramikplättchen dünn mit Glas beschichtet und dann bei einer Temperaturbehandlung mit dem anderen Keramikplättchen verklebt.

Ferner ist es möglich, die Keramikfolie als Substrat beidseitig dünn mit Glas zu beschichten, so dass auch beidseitig Leuchtstoff mit gleicher oder verschiedener Emission aufgebracht sein kann. Ähnliches ist auch mit einer Glaskeramik als Substrat möglich. Ausführungsformen, die aus Kombinationen der verschiedenen Varianten wie oben beschrieben bestehen, sind ebenfalls möglich.

Wesentlich ist, daß das Konversionselement aus einer Kombination von Glas und Substrat, nämlich Keramik oder Glaskeramik, besteht, wobei ein Leuchtstoff in Glas eingebettet ist. Die Glasmatrix kann u. U. gleichzeitig als Kleber für den Verbund von Chip und Konversionselement dienen. Das verwendete Glas sollte kompakt gewählt sein, d.h. aufgeschmolzen und blasenarm. Das Substrat, ob Keramik oder Glaskeramik, kann auch als lichtstreuendes Element dienen und ist zumindest transluzent. Das Substrat, ob Keramik oder Glaskeramik, kann auch selbst Leuchtstoff enthalten oder aus diesem bestehen.

Das optoelektronische Halbleiterbauelement kann eine LED oder auch ein Laser sein.

Die Erfindung betrifft ein optoelektronisches Halbleiterbauelement nach dem Oberbegriff des Patentanspruchs 1 und ein Verfahren zur Herstellung eines Konversionselements für ein optoelektronisches Halbleiterbauelement nach dem Oberbegriff des Patentanspruchs 9.

### Kurze Beschreibung der Zeichnungen

Im Folgenden soll die Erfindung anhand von mehreren Ausführungsbeispielen näher erläutert werden. Die Figuren zeigen:
- Figur 1: eine Konversions-LED gemäß dem Stand der Technik;
- Figur 2: eine LED mit neuartigem Konverterelement;
- Figur 3-7: je ein weiteres Ausführungsbeispiel für eine LED mit neuartigem Konverterelement;
- Figur 8: ein Substrat mit Poren und darin enthaltener Glasmatrix, die Leuchtstoffpartikel enthält.

### Bevorzugte Ausführung der Erfindung

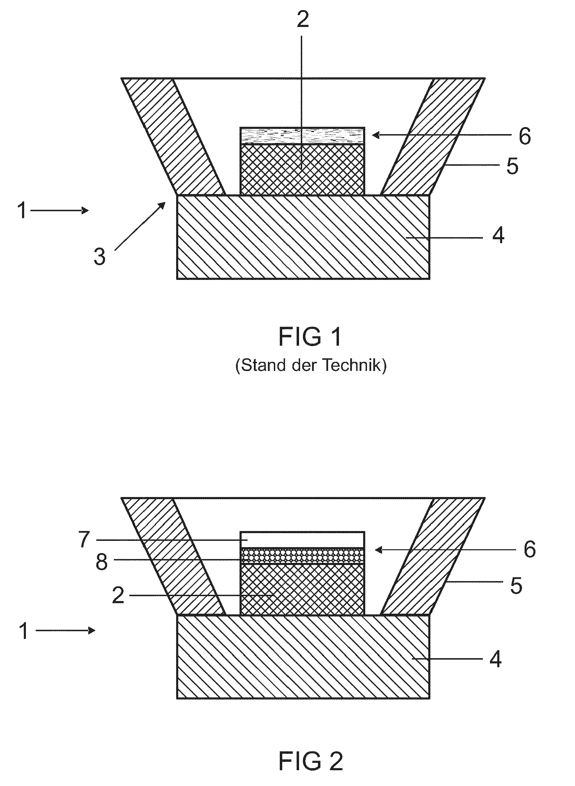

Figur 1 zeigt als Halbleiterbauelement eine Konversions-LED 1, die als primäre Strahlungsquelle einen Chip 2 vom Typ InGaN verwendet. Sie hat ein Gehäuse 3 mit einem Board 4, auf dem der Chip sitzt, und einem Reflektor 5. Dem Chip ist ein Konversionselement 6 vorgeschaltet, das teilweise die blaue Strahlung mittels eines Leuchtstoffs, beispielweise YAG:Ce, in längerwellige Strahlung konvertiert. Das Konversionselement 6 ist gemäß dem Stand der Technik plättchenförmig und weist ein Silikonbett auf, in dem Leuchtstoffpulver dispergiert ist. Die elektrischen Anschlüsse sind nicht dargestellt, sie entsprechen üblicher Technik.

Figur 2 zeigt ein erstes nicht-erfindungsgemäßes Ausführungsbeispiel. Dabei wird als Konversionselement 6 ein Substrat 7 aus Al2O3 verwendet, das transluzent ist und plättchenartig als Folie geformt ist. Auf das Substrat 7 ist eine dünne Glasschicht 8 aufgebracht, im Sinne einer Matrix. In dieser sind Leuchtstoffpartikel verteilt, die in die Glasmatrix eingesunken sind und von dieser vollständig bedeckt sind. Glasschicht 8 und Substrat 7 bilden ein Laminat, wobei die Seite des Substrats, auf der die Glasmatrix aufgetragen ist, dem Chip 2 zugewandt ist, oder auch abgewandt ist. Das Konversionselement ist mittels bekannter Kleber auf dem Chip angebracht (nicht dargestellt).

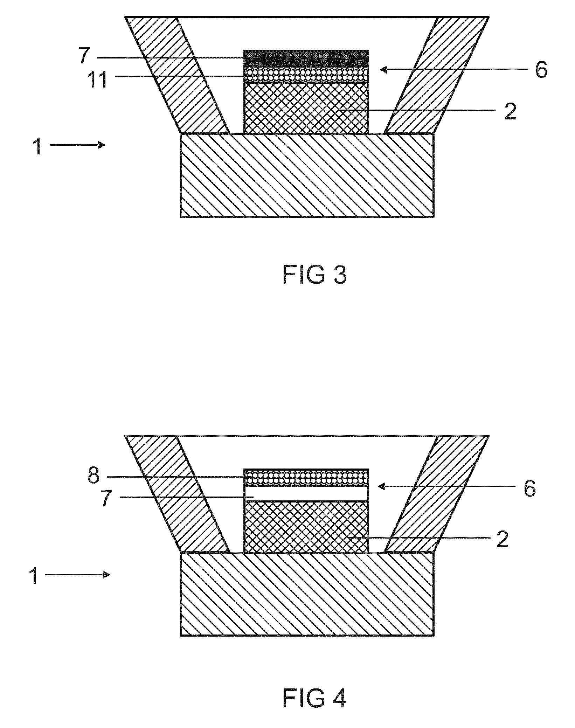

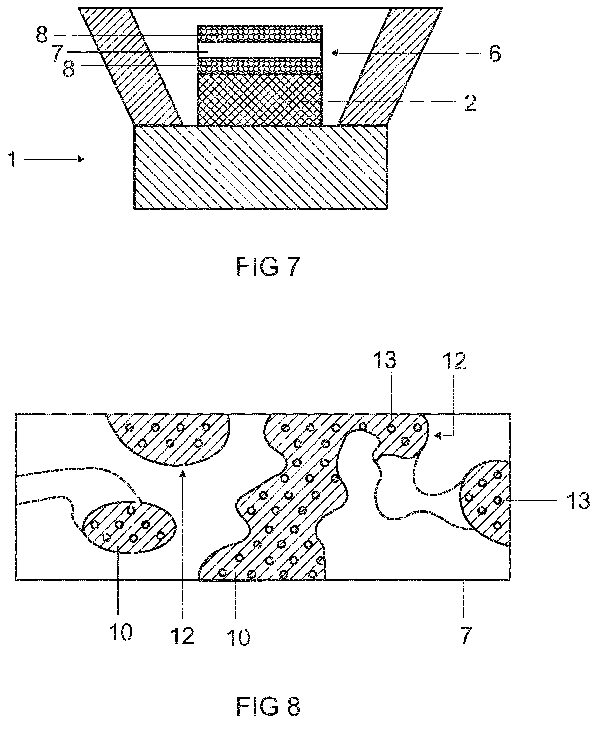

Figur 3 zeigt ein erfindungsgemäßes Ausführungsbeispiel einer LED 1, bei der die Folie aus Keramik oder Glaskeramik, die als Substrat 7 wirkt, nur kurz bei niedriger Temperatur angesintert ist. Deshalb hat sie viele offenen Poren. Die Glasmatrix füllt diese Poren aus. Durch Verwendung eines Überschusses an Glas verbleibt außerdem eine dünne Schicht 11 aus Glas auf der Oberfläche des Substrats. Der Leuchtstoff ist in der Glasmatrix sowohl im Bereich der dünnen Schicht 11 als auch im Bereich der Poren dispergiert. Eine ähnliche Konfiguration zeigt Figur 8 im Detail ohne Schicht 11. Dort ist das Substrat 7 mit offenen Poren 12 gezeigt. In die Poren ist die Glasmatrix 10 eingesogen. In der Glasmatrix sind Leuchtstoffkörner 13 dispergiert.

Figur 4 zeigt schematisch ein nichterfindungsgemäßes Ausführungsbeispiel einer LED 1, bei der das Substrat 7 über eine konventionelle Klebeschicht (nicht extra dargestellt) mit dem Chip 2 vom Typ InGaN, der blau emittiert (Peak bei etwa 440 bis 450 nm), verbunden ist. Die Glasmatrix 8 mit dem darin eingesunkenen Leuchtstoff ist auf der vom Chip abgewandten Seite des Substrats 7 befestigt. Die konventionelle Klebeschicht ist meist Silikon. Sie wird verwendet, wenn relativ temperaturempfindliche Chips verwendet werden.

Bei weniger temperaturempfindlichen Chips ist eine Klebeschicht aus hochbrechendem Glas vorteilhafter. Denn dann ist die Wärmeableitung besser und auch die Lichtauskopplung ist höher. Damit wird die Effizienz gesteigert.

Aus diesem Grund ist eine eigenständige technische Lösung, die vorgestellten hochbrechenden Gläser allein als Kleber (insbesondere in Richtung zum Chip oder zum Gehäuse) zu verwenden, also ohne Einbettung eines Leuchtstoffs. In diesem Fall wird der Leuchtstoff allein in das keramische Substrat eingebracht bzw. mehrere Leuchtstoffhaltige keramische Substrate können über einen derartigen Kleber miteinander verbunden werden.

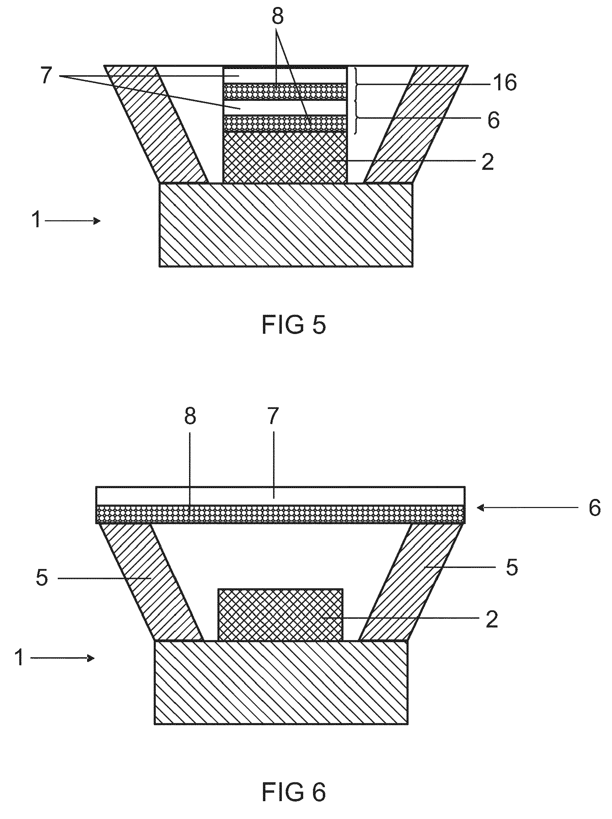

Figur 5 zeigt schematisch ein nicht-erfindungsgemäßes Ausführungsbeispiel einer LED 1, bei der eine doppelte Struktur des Konversionselements 6, 16 verwendet wird. Vom blau emittierenden Chip aus gesehen folgt auf eine erste Schicht 8 mit Glasmatrix und erstem Leuchtstoff, bevorzugt ein rot emittierender Leuchtstoff wie ein Nitridosilikat M2Si5N8:Eu, ein erstes Substrat 7, das wiederum mit einer zweiten Glasmatrix 8 verbunden ist, die wiederum mit einem zweiten Substrat 7 verbunden ist. Dabei wirkt die Glasmatrix 8 jeweils selbst als Kleber.

Geeignete Leuchtstoffe sind insbesondere YAG:Ce oder ein anderer Granat, Orthosilikat oder Sion, Nitridosilikat, Sialon, Calsin, etc..

Figur 6 zeigt ein nicht-erfindungsgemäßes Ausführungsbeispiel für eine LED 1, der ein Konversionselement 6 beabstandet vor den Chip 2 vorgeschaltet ist. Dabei trägt die Seitenwand 5 des Gehäuses, die als Reflektor wirkt, indem beispielsweise die Innenwand geeignet beschichtet ist, an ihrem Ende das Konversionselement 6. Wieder wirkt die Glasmatrix 8 auch als Kleber zur Seitenwand hin, das Substrat 7 ist vom Chip abgewandt. Das Konversionselement 6 verschließt die Öffnung des Reflektors.

Figur 7 zeigt ein nicht-erfindungsgemäßes Ausführungsbeispiel für eine LED 1, bei der ein Konversionselement 6 sandwichartig aufgebaut. Es verwendet einen UV-emittierenden Chip 2 mit etwa 380 nm Peakwellenlänge. Eine erste Glasmatrix 8 klebt direkt auf dem Chip 2, in ihr ist ein erster Leuchtstoff dispergiert, beispielsweise ein roter, UV-anregbarer Leuchtstoff wie das Calsin CaAlSiN3:Eu. Vor der ersten Glasmatrix sitzt ein Substrat 7 aus einer Mischung von YAG und YAG:Ce, das gelb emittiert. Ein zusätzlicher blau emittierender Leuchtstoff wie BAM:Eu ist in einer zweiten Glasmatrix 8 dispergiert, die außen vor dem Substrat 7 angebracht ist.

Nicht-erfindungsgemäße Ausführungsbeispiele eines Konverters für die Konversion des UV-Anteils in blaues Licht sind z. B. hocheffiziente Leuchtstoffe vom Typ (Ba_{0.4}Eu_{0.6}) MgAl₁₀O₁₇, (Sr_{0,96}Eu_{0,04})₁₀ (PO₄)₆Cl₂. Ein nicht-erfindungsgemäßes Ausführungsbeispiel eines Konverters für die Konversion des UV-Anteils in gelbes Licht ist z. B. (Sr_{1-x-y}CeₓLi_{y})₂Si₅N₈. Insbesondere liegt hier x und y jeweils im Bereich 0,1 bis 0,01. Besonders geeignet ist ein Leuchtstoff (Sr_{1-x-y}CeₓLi_{y})₂Si₅N₈, bei dem x=y. Nicht-erfindungsgemäße Ausführungsbeispiele eines Konverters für die Konversion des UV-Anteils in rotes Licht sind z. B. Nitridosilikate, Calsine oder Sione des Typs MSi2O2N2:Eu, die für sich genommen gut bekannt sind.

## Patentansprüche

1. Optoelektronisches Halbleiterbauelement (1) mit einer Lichtquelle, einem Gehäuse und elektrischen Anschlüssen, wobei die Lichtquelle einen Chip (2) aufweist, der primäre Strahlung im UV oder Blauen emittiert, deren Peakwellenlänge insbesondere im Bereich 300 bis 490 nm liegt, wobei die primäre Strahlung teilweise oder vollständig durch ein davor angebrachtes Konversionselement in Strahlung anderer Wellenlänge umgewandelt wird, **dadurch gekennzeichnet, dass** das Konversionselement ein transluzentes oder transparentes Substrat (7) aufweist, das aus Keramik oder Glaskeramik gefertigt ist, wobei das Substrat mit einer Glasmatrix (10) beaufschlagt ist, in die ein Leuchtstoff (13) eingebettet ist, wobei das Substrat Poren (12) aufweist, in die die Glasmatrix zumindest teilweise eingebracht ist.

2. Optoelektronisches Halbleiterbauelement nach Anspruch 1, **dadurch gekennzeichnet, dass** die Glasmatrix auf dem Substrat als Schicht aufgebracht ist.

3. Optoelektronisches Halbleiterbauelement nach Anspruch 1, **dadurch gekennzeichnet, dass** das Substrat und die Glasmatrix ein Laminat bilden.

4. Optoelektronisches Halbleiterbauelement nach Anspruch 1, **dadurch gekennzeichnet, dass** die Glasmatrix gleichzeitig als Kleber für einen Verbund von Chip und Konversionselement oder für einen Verbund zweier Konversionselemente dient.

5. Optoelektronisches Halbleiterbauelement nach Anspruch 1, **dadurch gekennzeichnet, dass** die Glasmatrix blasenarm oder im wesentlichen frei von Blasen ist.

6. Optoelektronisches Halbleiterbauelement nach Anspruch 1, **dadurch gekennzeichnet, dass** das Substrat selbst teilweise oder vollständig fluoreszierend ist.

7. Optoelektronisches Halbleiterbauelement nach Anspruch 1, **dadurch gekennzeichnet, dass** das Substrat auf beiden Seiten mit einer Glasmatrix beaufschlagt ist.

8. Optoelektronisches Halbleiterbauelement nach Anspruch 1, **dadurch gekennzeichnet, dass** das Konversionselement mittels eines Klebers auf dem Chip befestigt ist oder beabstandet vom Chip angebracht ist.

9. Verfahren zur Herstellung eines Konversionselements für ein optoelektronisches Halbleiterbauelement (1) nach einem der vorhergehenden Ansprüche, **dadurch gekennzeichnet, dass** in einem ersten Schritt ein Substrat (7) bereitgestellt wird, das aus Keramik oder Glaskeramik hergestellt ist, dann in einem zweiten Schritt Glas auf das Substrat aufgetragen wird, insbesondere als Glaspulver oder geschmolzenes Glas, wobei entweder Leuchtstoff zusammen mit dem Glas aufgetragen wird, oder Leuchtstoff nachträglich in das Glas eingebracht wird, wobei im zweiten Schritt eine Glasmatrix (10) durch Infiltrieren erzeugt wird, wobei das Substrat vorher so gesintert worden ist, dass es große Poren (12) enthält, wobei das Glas so ausreichend dünnflüssig gemacht wird, dass es durch Kapillarwirkung in die Poren des Substrats hineingezogen wird.

10. Verfahren nach Anspruch 9, **dadurch gekennzeichnet, dass** im zweiten Schritt eine Glasschicht laminiert wird, insbesondere entweder durch Siebdrucken von glasigem Pulver mit anschließender Verglasung oder durch Aufziehen von geschmolzenem Glas direkt auf das Substrat.

11. Verfahren nach Anspruch 10, **dadurch gekennzeichnet, dass** der Leuchtstoff anschließend durch Siebdrucken oder ein Sprühverfahren auf die Glasschicht aufgebracht wird und dann das Konversionselement soweit erwärmt wird, dass das Glas leicht erwärmt wird, so dass der Leuchtstoff in das Glas einsinkt und davon umschlossen wird.

12. Verfahren nach Anspruch 9, **dadurch gekennzeichnet, dass** im zweiten Schritt eine Glasschicht laminiert wird, die bereits mit Leuchtstoff versehen ist, insbesondere durch Siebdrucken von glasigem Pulver, das mit Leuchtstoffpulver vorher vermischt worden ist, mit anschließender Verglasung.

## Claims

1. Optoelectronic semiconductor component (1) having a light source, a housing and electrical connections, wherein the light source has a chip (2) which emits primary radiation in the UV or blue region with a peak wavelength in particular in the region of 300 to 490 nm, wherein the primary radiation is partially or completely converted into radiation of a different wavelength by a previously applied conversion element, **characterized in that** the conversion element has a translucent or transparent substrate (7), which is manufactured from ceramic or glass ceramic, wherein a glass matrix (10) is applied to the substrate, with a phosphor (13) being embedded in said glass matrix, wherein the substrate has pores (12), into which the glass matrix is introduced at least partially.

2. Optoelectronic semiconductor component according to Claim 1, **characterized in that** the glass matrix is applied to the substrate as a layer.

3. Optoelectronic semiconductor component according to Claim 1, **characterized in that** the substrate and the glass matrix form a laminate.

4. Optoelectronic semiconductor component according to Claim 1, **characterized in that** the glass matrix at the same time acts as adhesive for a composite structure comprising chip and conversion element or for a composite structure comprising two conversion elements.

5. Optoelectronic semiconductor component according to Claim 1, **characterized in that** the glass matrix has few bubbles or is substantially free of bubbles.

6. Optoelectronic semiconductor component according to Claim 1, **characterized in that** the substrate is itself partially or completely fluorescent.

7. Optoelectronic semiconductor component according to Claim 1, **characterized in that** a glass matrix is applied to both sides of the substrate.

8. Optoelectronic semiconductor component according to Claim 1, **characterized in that** the conversion element is fastened by means of an adhesive on the chip or is attached spaced apart from the chip.

9. Method for producing a conversion element for an optoelectronic semiconductor component (1) according to one of the preceding claims, **characterized in that**, in a first step, a substrate (7) is provided which is produced from ceramic or glass ceramic, then in a second step, glass is applied to the substrate, in particular in the form of glass powder or molten glass, wherein either phosphor is applied together with the glass, or phosphor is introduced subsequently into the glass, wherein in the second step, a glass matrix (10) is produced by infiltration, wherein the substrate has previously been sintered in such a way that it contains large pores (12), wherein the glass is made sufficiently fluid for it to be drawn into the pores of the substrate by the capillary effect.

10. Method according to Claim 9, **characterized in that** in the second step, a glass layer is laminated, in particular either by screen printing glass powder with subsequent vitrification or by drawing molten glass directly onto the substrate.

11. Method according to Claim 10, **characterized in that** the phosphor is then applied by screen printing or by a spraying method to the glass layer and then the conversion element is heated to such an extent that the glass is heated slightly, with the result that the phosphor sinks into the glass and is surrounded thereby.

12. Method according to Claim 9, **characterized in that** in the second step, a glass layer is laminated, which glass layer has already been provided with phosphor, in particular by screen printing of glass powder which has previously been mixed with phosphor powder, with subsequent vitrification.

## Revendications

1. Composant semi-conducteur opto-électronique (1) comportant une source de lumière, un boîtier et des raccordements électriques, la source de lumière comportant une puce (2) qui émet un rayonnement primaire UV ou bleu dont la longueur d'onde de pointe est plus particulièrement de l'ordre de 300 à 490 nm, le rayonnement primaire étant converti entièrement ou partiellement en un rayonnement ayant une autre longueur d'onde par un élément de conversion agencé devant, **caractérisé en ce que** l'élément de conversion comporte un substrat (7) translucide ou transparent réalisé en céramique ou céramique de verre, au substrat étant appliquée une matrice de verre (10) dans laquelle est noyée une substance luminescente (13), le substrat présentant des pores (12) dans lesquels la matrice de verre est introduite au moins en partie.

2. Composant semi-conducteur opto-électronique selon la revendication 1, **caractérisé en ce que** la matrice de verre est posée sur le substrat en tant que couche.

3. Composant semi-conducteur opto-électronique selon la revendication 1, **caractérisé en ce que** le substrat et la matrice de verre forment un stratifié.

4. Composant semi-conducteur opto-électronique selon la revendication 1, **caractérisé en ce que** la matrice de verre sert en même temps de colle pour un composite composé de la puce et de l'élément de conversion ou pour un composite composé de deux éléments de conversion.

5. Composant semi-conducteur opto-électronique selon la revendication 1, **caractérisé en ce que** la matrice de verre présente peu de bulles ou est sensiblement exempte de bulles.

6. Composant semi-conducteur opto-électronique selon la revendication 1, **caractérisé en ce que** le substrat lui-même est partiellement ou entièrement fluorescent.

7. Composant semi-conducteur opto-électronique selon la revendication 1, **caractérisé en ce qu'**une matrice de verre est appliquée au substrat des deux côtés.

8. Composant semi-conducteur opto-électronique selon la revendication 1, **caractérisé en ce que** l'élément de conversion est fixé à la puce au moyen d'une colle ou est monté à une distance de la puce.

9. Procédé de fabrication d'un élément de conversion pour un composant semi-conducteur opto-électronique (1) selon l'une des revendications précédentes, **caractérisé en ce que**, dans une première étape, un substrat (7) réalisé en céramique ou en céramique de verre est mis à disposition, **en ce qu'**ensuite, dans une deuxième étape, du verre est appliqué sur le substrat, en particulier sous la forme de poudre de verre ou de verre fondu, de la substance luminescente étant appliquée avec le verre ou de la substance luminescente étant introduite ultérieurement dans le verre, une matrice de verre (10) étant, à la deuxième étape, créée par infiltration, le substrat ayant été préalablement fritté de telle sorte qu'il contient des pores (12) de grande taille, le verre étant rendu suffisamment fluide pour être aspiré par capillarité dans les pores du substrat.

10. Procédé selon la revendication 9, **caractérisé en ce que**, à la deuxième étape, une couche de verre est laminée, en particulier par application par impression sérigraphique de poudre de verre avec vitrification subséquente ou par application de verre fondu directement sur le substrat.

11. Procédé selon la revendication 10, **caractérisé en ce que** la substance luminescente est ensuite appliquée par impression sérigraphique ou par un procédé de pulvérisation sur la couche de verre et **en ce que** l'élément de conversion est ensuite chauffé jusqu'à ce que le verre soit légèrement chauffé, de sorte que la substance luminescente s'enfonce dans le verre et en est entourée.

12. Procédé selon la revendication 9, **caractérisé en ce qu'**est laminée, à la deuxième étape, une couche de verre qui est déjà pourvue de substance luminescente, en particulier par application par impression sérigraphique de poudre de verre préalablement mélangée à de la poudre de substance luminescente, avec vitrification subséquente.
